# EUROPÄISCHE PATENTANMELDUNG

(11) **EP 4 837 673 A2**
(43) Veröffentlichungstag der Anmeldung: **11.11.2026**
(21) Anmeldenummer: 26169529.0
(22) Anmeldetag: 31.03.2026
(51) Int. Cl.: B21F 3/02, B21F 35/00, B65G 51/02, B24B 7/16

(54) **SYSTEM ZUR HERSTELLUNG VON SCHRAUBENFEDERN AUS DRAHT, AUFNAHMEEINRICHTUNG FÜR EIN SOLCHES SYSTEM, KLEMMEINRICHTUNG FÜR EIN SOLCHES SYSTEM**

(30) Priorität: 14.04.2025 DE 102025114583
(71) Anmelder: WAFIOS Aktiengesellschaft, 72764 Reutlingen (DE)
(72) Erfinder: Fries, Stefan, 72764 Reutlingen (DE); Krauß, Sarah, 72184 Eutingen (DE); Speidel, Lares, 72116 Mössingen (DE); Walz, Bernd, 72793 Pfullingen (DE); Weiblen, Frank, 72555 Metzingen (DE)
(74) Vertreter: Patentanwälte Ruff, Wilhelm, Beier, Dauster & Partner mbB

(57) **Zusammenfassung**

Die Erfindung betrifft ein System (1) zur Herstellung von Schraubenfedern (2) aus Draht (3), aufweisend eine Federwindemaschine (4), die eine Umformeinrichtung (5A, 5B) zum Umformen ihr zugeführten Drahts (3) in eine Schraubenfeder (2) aufweist, sowie eine Schnitteinrichtung (5C) zum Abtrennen einer jeweiligen umgeformten Schraubenfeder (2), und ein Fördersystem (6) zum Transportieren abgetrennter Schraubenfedern (2) von der Federwindemaschine (4) zu einer Nachfolgeeinrichtung (7) des Systems (1), wobei das Fördersystem (6) eine Aufnahmeeinrichtung (11) aufweist, die eine Eintrittsöffnung (9) aufweist und einen Initialabschnitt (10) einer Rohrleitung (8) des Fördersystems (6) definiert und die zum Übernehmen von der Federwindemaschine (4) in einer Förderrichtung (12) des Fördersystems (6) weg zu transportierender Schraubenfedern (2) ausgebildet ist, wobei die Aufnahmeeinrichtung (11) einen Innenraum (13) aufweist, der den Initialabschnitt (10) der Rohrleitung (8) ausbildet und in welchen hinein durch die Eintrittsöffnung (9) hindurch ein bereits umgeformter Federabschnitt (14) einer jeweiligen noch in Umformung befindlichen Schraubenfeder (2) einführbar ist, wobei sich der Innenraum (13) von der Eintrittsöffnung (9) weg gerichtet aufweitet, um einen Bewegungsfreiraum für den innerhalb des Innenraums (13) befindlichen bereits umgeformten Federabschnitt (14) bereitzustellen.

## Beschreibung

Die Erfindung betrifft mit zwei Erfindungsaspekten jeweils ein System zur Herstellung von Schraubenfedern aus Draht. Die Erfindung betrifft zudem eine Aufnahmeeinrichtung für ein solches System sowie eine Klemmeinrichtung für ein derartiges System.

Schraubenfedern sind Maschinenelemente, die in zahlreichen Anwendungsbereichen in großen Stückzahlen und unterschiedlichen Ausgestaltungen benötigt werden. Schraubenfedern, die auch als gewundene Torsionsfedern bezeichnet werden, werden üblicherweise aus Federdraht hergestellt und je nach der bei Nutzung vorliegenden Belastung als Zugfedern oder Druckfedern ausgelegt.

Schraubenfedern werden heutzutage üblicherweise durch Federwinden mithilfe numerisch gesteuerter Federwindemaschinen hergestellt. Dabei wird ein Draht (Federdraht) unter der Steuerung durch ein NC-Steuerprogramm einer Umformeinrichtung der Federwindemaschine zugeführt und mithilfe von Werkzeugen der Umformeinrichtung, zum Beispiel von Windestiften und einem oder mehreren Steigungswerkzeugen, zu einer Schraubenfeder umgeformt. Nach Abschluss einer Umformoperation wird die fertiggestellte Schraubenfeder unter der Steuerung durch das NC-Steuerprogramm mittels einer Schnitteinrichtung von dem zugeführten Draht abgetrennt.

Häufig schließen sich weitere Bearbeitungsschritte und/oder Kontrollschritte an den Umformprozess an, um aus der fertig gewundenen und von dem Draht abgetrennten Schraubenfeder eine gebrauchsfertige Schraubenfeder mit den gewünschten mechanischen und geometrischen Eigenschaften zu erhalten. Daher sind Federwindemaschinen häufig in ein komplexes System (Fertigungssystem) integriert, welches zusätzlich zu (wenigstens) einer Federwindemaschine (wenigstens) eine Nachfolgeeinrichtung sowie ein Fördersystem zum Transportieren der Schraubenfedern von der Federwindemaschine zur Nachfolgeeinrichtung umfasst. Eine Nachfolgeeinrichtung kann zum Beispiel eine Wärmebehandlungseinheit aufweisen und/oder eine Kontrollstation zur Kontrolle geometrischer Eigenschaften der Schraubenfeder (zum Beispiel Federlänge). Bei Schraubenfedern, die für ihre Anbindung geschliffene Enden benötigen, kann sich auch eine Federendenschleifmaschine als Nachfolgeeinrichtung anschließen.

Fertigungssysteme der vorstehend erläuterten Art sind beispielsweise aus der DE 10 2020 209 068 A1 sowie aus der DE 10 2021 211 526 A1 bekannt.

Es ist eine Aufgabe der vorliegenden Erfindung, ein System zur Herstellung von Schraubenfedern aus Draht, eine Aufnahmeeinrichtung für ein derartiges System sowie eine Klemmeinrichtung für ein derartiges System zu schaffen, die jeweils besondere, insbesondere verbesserte, Eigenschaften aufweisen.

Diese Aufgabe wird gelöst durch die Gegenstände der unabhängigen Patentansprüche. Bevorzugte Ausführungsformen sind Gegenstand der abhängigen Patentansprüche. Der Wortlaut sämtlicher Ansprüche wird durch ausdrückliche Bezugnahme zum Inhalt der vorliegenden Beschreibung gemacht.

Ein erfindungsgemäßes System dient der Herstellung von Schraubenfedern aus Draht. Dabei weist das System eine Federwindemaschine auf, welche zumindest eine Umformeinrichtung zum Umformen von der Federwindemaschine zugeführtem Draht in eine Schraubenfeder hat. Zudem weist die Federwindemaschine eine Schnitteinrichtung auf, die zum Abtrennen einer jeweiligen fertig umgeformten Schraubenfeder von dem zugeführten Draht ausgebildet ist. Das System hat ein Fördersystem, welches zum Transportieren abgetrennter Schraubenfedern von der Federwindemaschine weg zu einer Nachfolgeeinrichtung des Systems hin ausgebildet ist. Das Fördersystem weist dabei eine Rohrleitung auf, die eine Eintrittsöffnung hat. Durch die Eintrittsöffnung hindurch tritt eine jeweilige noch nicht abgetrennte Schraubenfeder in die Rohrleitung des Fördersystems hinein, um daraufhin durch die Rohrleitung hindurch transportiert zu werden. Ein Initialabschnitt der Rohrleitung weist die Eintrittsöffnung auf. Die Eintrittsöffnung kann insofern ein in einer Förderrichtung des Fördersystems vorderstes Ende des Initialabschnitts der Rohrleitung definieren. Das Fördersystem hat eine Aufnahmeeinrichtung, die dazu ausgebildet ist, Schraubenfedern aufzunehmen, welche von der Federwindemaschine in der Förderrichtung weg transportiert werden sollen. Dabei weist die Aufnahmeeinrichtung die Eintrittsöffnung auf und definiert den Initialabschnitt der Rohrleitung. Die Aufnahmeeinrichtung hat einen Innenraum, welcher den Initialabschnitt der Rohrleitung ausbildet. In den Innenraum hinein wird ein bereits umgeformter Federabschnitt einer jeweiligen noch in Umformung befindlichen Schraubenfeder durch die Eintrittsöffnung hindurch eingeführt, insbesondere um mit fortschreitender Umformung weiter in den den Initialabschnitt der Rohrleitung ausbildenden Innenraum hinein vorgeschoben zu werden.

Gemäß einem ersten Aspekt der Erfindung weitet sich der Innenraum der Aufnahmeeinrichtung von der Eintrittsöffnung weg gerichtet auf. Der, insbesondere trichterartig, aufgeweitete Innenraum stellt dabei einen Bewegungsfreiraum für den innerhalb des Innenraums befindlichen bereits umgeformten Federabschnitt bereit. Auf diese Weise kann ein besonders sanfter Führungskontakt der noch in Umformung befindlichen Schraubenfeder mit der Aufnahmeeinrichtung erreicht werden, insbesondere um einer unerwünschten Verformung der noch in Umformung befindlichen Schraubenfeder durch den Kontakt mit der Aufnahmeeinrichtung entgegenzuwirken. Dies kann insbesondere bei der Herstellung besonders filigraner Schraubenfedern von Vorteil sein, wie sie beispielsweise im medizintechnischen Bereich Anwendung finden können.

Gemäß einem zweiten Aspekt der Erfindung weist das Fördersystem des Systems eine Klemmeinrichtung auf, die zum Beruhigen einer jeweiligen durch die Rohrleitung hindurch zu transportierenden Schraubenfeder ausgebildet ist. Die Klemmeinrichtung kann insbesondere zum zeitweisen Einklemmen und/oder Festhalten der betreffenden Schraubenfeder in der Rohrleitung ausgebildet sein. Dabei hat die Klemmeinrichtung eine mit einem Füllfluid, insbesondere Druckfluid, befüllbare Druckkammer. Die Druckkammer ist zum kammerinnendruckabhängigen Einstellen eines Innendurchmessers der Klemmeinrichtung ausgebildet. Insbesondere kann die Druckkammer mit Füllfluid aufgepumpt werden, um den Innendurchmesser der Klemmeinrichtung zu verringern. Umgekehrt kann Füllfluid aus der Druckkammer abgelassen werden, um den Innendurchmesser zu vergrößern. Der Innendurchmesser kann zwischen einem Minimalwert und einem Maximalwert einstellbar sein, wobei der Minimalwert beispielsweise 80 % bis 99 % des Maximalwerts betragen kann. Die Klemmeinrichtung hat eine Umfangswand, die den einstellbaren Innendurchmesser definiert. Insbesondere weist die Umfangswand den Innendurchmesser radial innen auf. Insbesondere begrenzt die Umfangswand mit ihrer Innenseite eine Durchgangsöffnung. Ein insbesondere kreisförmiger Öffnungsquerschnitt der Durchgangsöffnung kann den Innendurchmesser aufweisen. Die Durchgangsöffnung bildet insbesondere einen Rohrleitungsabschnitt der Rohrleitung aus. Die Umfangswand ist zum Beruhigungsberühren der betreffenden Schraubenfeder ausgebildet. Insbesondere ist die Umfangswand durch Druckbefüllen der Druckkammer elastisch verformbar, um den Innendurchmesser an einen Außendurchmesser der zu beruhigenden Schraubenfeder anzupassen. Durch, insbesondere klemmendes, Anlegen der Umfangswand an eine jeweilige momentan von der Umfangswand umgebenden Schraubenfeder kann die betreffende Schraubenfeder schwingungsberuhigt werden. In einem schwingungsberuhigten Zustand der betreffenden Schraubenfeder kann eine besonders präzise, insbesondere optische, Vermessung der Schraubenfeder, insbesondere in einem schwingungsberuhigten Federabschnitt der Schraubenfeder, erfolgen. Das Beruhigungsberühren mittels der Klemmeinrichtung kann von besonderem Vorteil sein, wenn besonders filigrane Schraubenfedern mittels des Systems hergestellt werden, wie sie beispielsweise im medizintechnischen Bereich Anwendung finden können.

Die beiden Aspekte der Erfindung können gemeinsam, also in ein und demselben System zur Herstellung von Schraubenfedern, realisiert werden. Alternativ können die beiden Erfindungsaspekte unabhängig voneinander realisiert werden, so dass das System zur Herstellung von Schraubenfedern entweder gemäß dem ersten Aspekt der Erfindung oder gemäß dem zweiten Aspekt der Erfindung ausgebildet ist.

**In** Ausgestaltung der Erfindung, insbesondere zumindest ausgehend von dem ersten Erfindungsaspekt, weist die Aufnahmeeinrichtung eine Übertrittsöffnung auf, die der Eintrittsöffnung in der Förderrichtung, insbesondere fluchtend, gegenüberliegt. Die Übertrittsöffnung ist zum Übertritt einer jeweiligen Schraubenfeder aus dem Initialabschnitt der Rohrleitung heraus in einen auf den Initialabschnitt der Rohrleitung, insbesondere direkt, folgenden Rohrleitungsabschnitt der Rohrleitung hinein ausgebildet. Insbesondere ist die Übertrittsöffnung, mehr insbesondere öffnungsquerschnittsmäßig, kleiner als die Eintrittsöffnung. Die Übertrittsöffnung kann so auf einen Außendurchmesser der Schraubenfeder abgestimmt sein, dass die Schraubenfeder entlang ihrer Axialerstreckung in Förderrichtung durch den Rohrleitungsabschnitt führbar ist und/oder dass sich die Schraubenfeder bei Übertritt durch die Übertrittsöffnung hindurch selbsttätig entlang der Förderrichtung ausrichtet.

In weiterer Ausgestaltung der Erfindung, insbesondere zumindest ausgehend von dem ersten Erfindungsaspekt, weitet sich der Innenraum von der Eintrittsöffnung weg gerichtet nur bis zu einer Weitstelle des Innenraums auf. Die Weitstelle kann insbesondere dort vorhanden sein, wo der Innenraum senkrecht zur Förderrichtung seine weiteste Erstreckung hat. Von der Weitstelle ausgehend verjüngt sich der Innenraum von der Eintrittsöffnung weg gerichtet, insbesondere in Förderrichtung, bis zu der Übertrittsöffnung, insbesondere trichterartig.

Zweckmäßig verläuft ein bezüglich einer Vertikalrichtung des Systems, die insbesondere einer Schwerkraftrichtung entspricht, unterer Innenflächenabschnitt der Aufnahmeeinrichtung von der Eintrittsöffnung zur Übertrittsöffnung parallel zu der Förderrichtung, wobei der untere Innenflächenabschnitt den Innenraum teilweise definiert.

Zweckmäßig liegt dem in Vertikalrichtung unteren Innenflächenabschnitt ein den Innenraum teilweise definierender oberer Innenflächenabschnitt der Aufnahmeeinrichtung gegenüber. Der obere Innenflächenabschnitt kann zwischen der Weitstelle und der Übertrittsöffnung bereichsweise spitzwinklig zu der Förderrichtung längserstreckt sein, um die Verjüngung des Innenraums von der Weitstelle weg zu der Übertrittsöffnung hin auszubilden. Zwischen der Weitstelle und der Übertrittsöffnung kann der obere Innenflächenabschnitt bereichsweise zum Entlanggleiten eines axialen Schraubenendes des Federabschnitts bei laufender Umformung dienen, um dieses Schraubenende der Übertrittsöffnung zuzuführen.

In weiterer Ausgestaltung der Erfindung, insbesondere zumindest ausgehend von dem ersten Erfindungsaspekt, weist die Aufnahmeeinrichtung zwei einander gegenüberliegende Innenflankenflächen auf, die den Innenraum jeweils teilweise definieren. Dabei verlaufen die beiden Innenflankenflächen jeweils parallel zu der Förderrichtung.

In weiterer Ausgestaltung der Erfindung, insbesondere zumindest ausgehend von dem ersten Erfindungsaspekt, verläuft zumindest eine der Innenflankenflächen der Aufnahmeeinrichtung im Wesentlichen vertikal, insbesondere parallel zur Vertikalrichtung des Systems. "Im Wesentlichen" kann dabei Winkelabweichungen von 5 % bis 10 % einbeziehen.

In weiterer Ausgestaltung der Erfindung verläuft zumindest eine der Innenflankenflächen nicht-vertikal, insbesondere schrägwinkelig zu einer Vertikalrichtung des Systems. Es kann bei manschen Ausgestaltungen zweckmäßig sein, wenn beide Innenflankenflächen schrägwinkelig zu der Vertikalrichtung verlaufen.

In weiterer Ausgestaltung der Erfindung, insbesondere zumindest ausgehend von dem ersten Erfindungsaspekt, verlässt der bereits umgeformte Federabschnitt einer jeweiligen noch in Umformung befindlichen Schraubenfeder die Federwindemaschine unter einem, insbesondere federwindungssteigungsabhängigen, Schrägwinkel relativ zu der Vertikalrichtung des Systems. Dabei ist ein Winkel zwischen zumindest einer, insbesondere nicht-vertikal verlaufenden, der Innenflankenflächen und der Vertikalrichtung auf den Schrägwinkel derart abgestimmt, dass sich der Federabschnitt im Laufe der Umformung zumindest zeitweise an die betreffende, insbesondere schräge, Innenflankenfläche anlegt. Der Winkel und/oder der Schrägwinkel kann beispielsweise minimal 30° und/oder maximal 60°, insbesondere 40° bis 50° betragen.

Zweckmäßig kann eine der Innenflankenflächen unter dem Winkel schräg zu der Vertikalrichtung angestellt verlaufen, während die andere Innenflankenfläche im Wesentlichen parallel zur Vertikalrichtung verläuft. Auf diese Weise kann eine tortenstückartige Querschnittsformgebung des Innenraums realisiert werden. Es kann alternativ zweckmäßig sein, wenn beide Innenflankenflächen parallel zueinander verlaufen. Die parallel zueinander verlaufenden Innenflankenflächen können eine langlochartige Querschnittsformgebung des Innenraums bereichsweise definieren.

In weiterer Ausgestaltung der Erfindung, insbesondere zumindest ausgehend von dem ersten Erfindungsaspekt, hat das System eine Messkamera, die zum Erfassen einer jeweiligen Schraubenfeder in einer quer zu der Förderrichtung orientierten Erfassungsrichtung der Messkamera ausgebildet ist. Die Messkamera kann insofern seitlich auf die Schraubenfeder blicken. Dabei ist die Messkamera in Förderrichtung, insbesondere direkt, vor der Eintrittsöffnung angeordnet. Die Messkamera kann die jeweilige Schraubenfeder in einem Erfassungsbereich erfassen, welcher zwischen der Aufnahmeeinrichtung und der Federwindemaschine angeordnet ist.

In weiterer Ausgestaltung der Erfindung, insbesondere zumindest ausgehend von dem ersten Erfindungsaspekt, hat das System eine, insbesondere weitere, Messkamera. Die, insbesondere weitere, Messkamera dient zum Erfassen einer jeweiligen Schraubenfeder entlang einer quer zu der Förderrichtung orientierten, insbesondere weiteren, Erfassungsrichtung der, insbesondere weiteren, Messkamera. Dabei ist die, insbesondere weitere, Messkamera in Förderrichtung, insbesondere direkt, hinter der Übertrittsöffnung der Aufnahmeeinrichtung oder, insbesondere direkt, vor der Übertrittsöffnung angeordnet. Die weitere Messkamera kann eine Erfassung der betreffenden Schraubenfeder in einem weiteren Erfassungsbereich ermöglichen, der in Förderrichtung im Abstand zu der Eintrittsöffnung angeordnet ist.

In weiterer Ausgestaltung der Erfindung, insbesondere zumindest ausgehend von dem ersten Erfindungsaspekt, weist die Aufnahmeeinrichtung ein, insbesondere ausgespartes, Kamerafenster auf. Durch das Kamerafenster hindurch ist die jeweilige Schraubenfeder mittels der, insbesondere weiteren, Messkamera erfassbar. Dabei öffnet das Kamerafenster den Innenraum quer zu der Förderrichtung, insbesondere horizontal. Mittels des Kamerafensters kann der Innenraum lichtdurchlässig und/oder fluiddurchlässig geöffnet sein.

Zweckmäßig kann dem Kamerafenster gegenüberliegend eine Lichteinlassöffnung für eine Gegenlichteinrichtung vorhanden sein, zwischen welcher und der Messkamera die betreffende Schraubenfeder bei dem Vermessen angeordnet wird.

In weiterer Ausgestaltung der Erfindung, insbesondere zumindest ausgehend von dem ersten Erfindungsaspekt, hat die Eintrittsöffnung einen von dem Innenraum weg weisenden Öffnungsrand. Der Öffnungsrand der Eintrittsöffnung kann insbesondere ein entgegen der Förderrichtung äußerstes Ende der Rohrleitung definieren. Der Öffnungsrand ist gefast oder gerundet ausgebildet. An dem Öffnungsrand kann also eine Fase oder eine Rundung vorgesehen sein. Insbesondere ist der Öffnungsrand zumindest oder nur teilweise gefast oder gerundet ausgebildet. Die Fase beziehungsweise Rundung kann ein Einführen der Schraubenfeder in den Innenraum hinein begünstigen. Beispielsweise kann ein bezüglich der Vertikalrichtung unterer Bereich des Öffnungsrands gefast oder gerundet ausgebildet sein, wohingegen ein oberer Bereich des Öffnungsrands im Wesentlichen ohne eine solche Fase beziehungsweise Rundung ausgebildet ist.

In weiterer Ausgestaltung der Erfindung, insbesondere zumindest ausgehend von dem zweiten Erfindungsaspekt, ist die Druckkammer ringförmig umlaufend ausgebildet. Alternativ oder zusätzlich begrenzt die Umfangswand die Druckkammer teilweise.

Zweckmäßig kann die Umfangswand einen die Druckkammer radial innenbegrenzenden, insbesondere elastisch verformbaren, Innenmantel ausbilden.

In weiterer Ausgestaltung der Erfindung, insbesondere zumindest ausgehend von dem zweiten Erfindungsaspekt, weist das System eine, insbesondere andere, Messkamera auf, die zum Erfassen einer jeweiligen Schraubenfeder entlang einer quer zu der Förderrichtung orientierten, insbesondere anderen, Erfassungsrichtung ausgebildet ist. Dabei ist die, insbesondere andere, Messkamera, in Förderrichtung, insbesondere direkt, hinter der Druckkammer angeordnet. Insofern kann mittels der, insbesondere anderen, Messkamera, ein mithilfe der Klemmeinrichtung schwingungsberuhigter Federabschnitt der Schraubenfeder erfasst werden.

In weiterer Ausgestaltung der Erfindung, insbesondere ausgehend von dem ersten und/oder dem zweiten Erfindungsaspekt, weist das Fördersystem eine Düseneinrichtung auf, die zum Einspeisen eines Treibfluides in die Rohrleitung und zum Antreiben von Schraubenfedern durch die Rohrleitung hindurch ausgebildet ist. Dabei mündet die Düseneinrichtung in Förderrichtung hinter dem Initialabschnitt in die Rohrleitung ein. Mittels des Treibfluides können die Schraubenfedern durch die Rohrleitung hindurch rohrpostähnlich gefördert werden. Die Düseneinrichtung kann zur Erzeugung eines Unterdrucks in dem Initialabschnitt der Rohrleitung ausgebildet sein. Insofern kann die Aufnahmeeinrichtung eine Federeinsaugeinrichtung zum Einsaugen zu transportierender Federn mittels des Unterdrucks sein.

Zweckmäßig handelt es sich bei dem Treibfluid um ein Gas, insbesondere um Luft, mehr insbesondere um Druckluft. Alternativ oder zusätzlich kann es sich bei dem Füllfluid zum Befüllen der Druckkammer um ein Gas, insbesondere um Luft, mehr insbesondere um Druckluft, handeln.

Zweckmäßig können das Treibfluid und das Füllfluid von derselben Versorgungsquelle stammen.

In weiterer Ausgestaltung der Erfindung, insbesondere zumindest ausgehend von dem zweiten Erfindungsaspekt, weisen die Klemmeinrichtung und die Düseneinrichtung ein gemeinsames Gehäuse auf. Die Klemmeinrichtung und die Düseneinrichtung können also integral miteinander ausgebildet sein.

Eine erfindungsgemäße Aufnahmeeinrichtung ist zur Verwendung in einem erfindungsgemäßen System, insbesondere in einem zumindest dem ersten Aspekt der Erfindung entsprechenden System, ausgebildet. Dabei ist die Aufnahmeeinrichtung als einteilige oder mehrteilige Adaptereinrichtung zum Anschließen an einen Rohrleitungsabschnitt des Fördersystems ausgebildet. Alternativ oder zusätzlich ist zumindest ein den Innenraum definierender Abschnitt der Aufnahmeeinrichtung monolithisch ausgebildet und/oder additiv hergestellt. "Additiv hergestellt" kann synonym zu "3D gedruckt" verstanden werden.

Eine erfindungsgemäße Klemmeinrichtung ist zur Verwendung in einem erfindungsgemäßen System, insbesondere in einem zumindest dem zweiten Erfindungsaspekt entsprechenden System, ausgebildet. Die Umfangswand der Klemmeinrichtung bildet einen Rohrleitungsabschnitt aus, welcher zum fluidleitenden Anschließen des Innenraums der Aufnahmeeinrichtung des Systems angepasst ist. Alternativ oder zusätzlich ist ein Gehäuse der Klemmeinrichtung monolithisch ausgebildet und/oder additiv hergestellt.

Weitere Vorteile und Merkmale der Erfindung ergeben sich aus den Ansprüchen sowie aus der nachfolgenden Beschreibung bevorzugter Ausführungsbeispiele der Erfindung, die anhand der Zeichnungen dargestellt sind. Dabei beziehen sich gleiche Bezugszeichen auf gleiche oder ähnliche oder funktional gleiche Bauteile.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

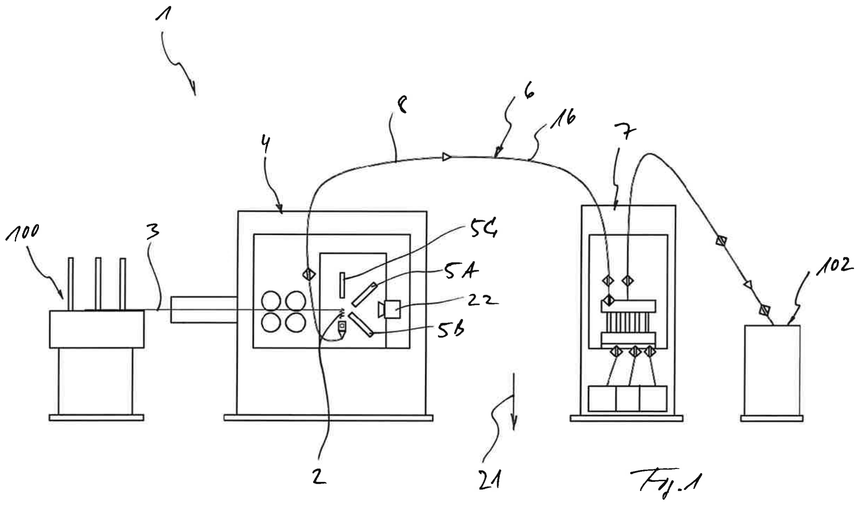

- Fig. 1: zeigt in schematischer Seitenansicht ein System zur Herstellung von Schraubenfedern aus Draht gemäß einer Ausführungsform der Erfindung,

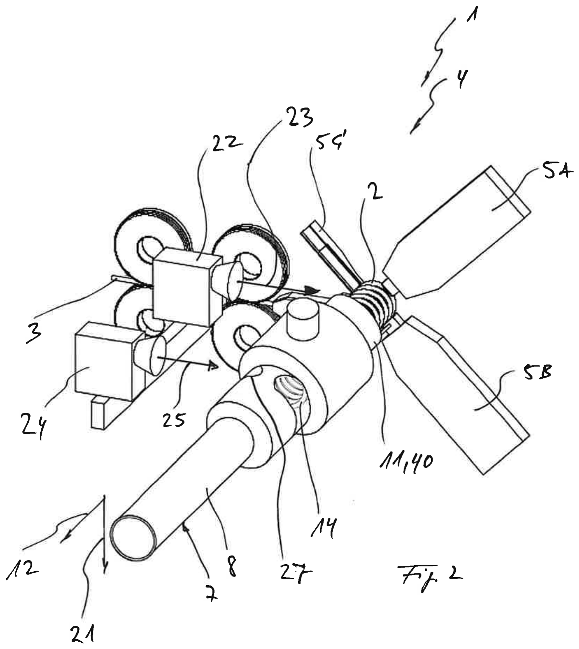

- Fig. 2: in schematischer Perspektivdarstellung ein Detail des Systems nach Fig. 1,
- Fig. 3: in schematischer Perspektivdarstellung eine Aufnahmeeinrichtung gemäß einer weiteren Ausführungsform der Erfindung,
- Fig. 4: in schematischer Frontaldarstellung die Aufnahmeeinrichtung nach Fig. 3,
- Fig. 5: in schematischer Schnittdarstellung die Aufnahmeeinrichtung nach den Fig. 3 und 4,
- Fig. 6: in schematischer Perspektivdarstellung eine Aufnahmeeinrichtung gemäß einer weiteren Ausführungsform der Erfindung,
- Fig. 7: in schematischer Frontaldarstellung die Aufnahmeeinrichtung nach Fig. 6,
- Fig. 8: in schematischer Schnittdarstellung die Aufnahmeeinrichtung nach den Fig. 6 und 7,
- Fig. 9: in schematischer Perspektivdarstellung eine Aufnahmeeinrichtung gemäß einer weiteren Ausführungsform der Erfindung,
- Fig. 10: in schematischer Perspektivdarstellung eine Aufnahmeeinrichtung gemäß einer weiteren Ausführungsform der Erfindung, und

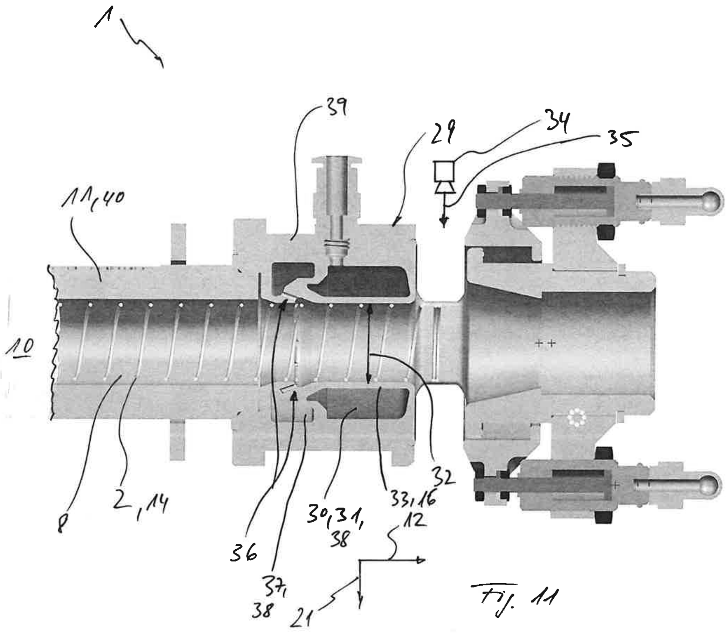

- Fig. 11: in schematischer Schnittdarstellung eine Klemmeinrichtung gemäß einer weiteren Ausführungsform der Erfindung.

Ein System 1 ist zur Herstellung von Schraubenfedern 2 aus Draht 3 vorgesehen. Bei einer solchen herzustellenden Schraubenfeder 2 kann es sich um eine Schraubendruckfeder oder um eine Schraubenzugfeder jeweils mit zylindrischer oder von der Zylinderform abweichenden Gestalt handeln. Der Federdurchmesser ist bei zylindrischen Schraubenfedern 2 über die axiale Länge der Schraubenfedern 2 konstant. Es gibt auch Schraubenfedern 2 mit über die Länge variierendem Federdurchmesser, zum Beispiel kegelförmige oder tonnenförmige Schraubenfedern 2. Auch die Gesamtlänge der (unbelasteten) Schraubenfeder 2 kann für unterschiedliche Anwendungen stark variieren. Betreffendes kann im Hinblick auf eine Steigung von Windungen von Schraubenfedern 2 gelten.

Das System 1 weist eine Federwindemaschine 4 auf. Die Federwindemaschine 4 kann so aufgebaut sein und arbeiten, wie in der DE 10 2010 014 385 B4 beschrieben. Auch andere Ausgestaltungen sind möglich.

Die Federwindemaschine 4 hat eine Umformeinrichtung 5A, 5B zum Umformen von der Umformeinrichtung 5A, 5B zugeführtem Draht 3 in eine Schraubenfeder 2. Die Federwindemaschine 4 hat außerdem eine Schnitteinrichtung 5C, die zum Abtrennen einer jeweiligen fertig umgeformten Schraubenfeder 2 von dem zugeführtem Draht 3 ausgebildet ist.

Zur Herstellung von Schraubenfedern 2 aus Draht 3 kann der Draht 3 als Ausgangsmaterial von einem "endlosen" Drahtvorrat mittels einer Zuführeinrichtung zu der Federwindemaschine 4 gefördert werden. Vorliegend handelt es sich um eine computernumerisch gesteuerte Federmaschine 4. In der Federwindemaschine 4 werden Abschnitte des Drahts 3 mittels einer Einzugseinrichtung sukzessive der Umformeinrichtung 5A, 5B zugeführt und dort jeweils in einer Umformoperation zu Schraubenfedern 2 umgeformt.

Die Umformeinrichtung 5A, 5B weist insbesondere Umformwerkzeuge auf, zum Beispiel Windestifte und gegebenenfalls ein oder mehrere Steigungswerkzeuge. Jede Schraubenfeder 2 wird vorliegend nach der Umformoperation mithilfe einer Schnitteinrichtung 5C von dem zugeführten Draht 3 abgetrennt. Die abgetrennten Schraubenfedern 2 werden danach sukzessive, also Stück für Stück nacheinander, durch eine Rohrleitung 8 eines Fördersystems 6 des Systems 1 hindurch in eine Federaufnahme einer Nachfolgeeinrichtung 7 des Systems 1 transportiert.

Die Federwindemaschine 4 hat beispielsweise eine mit Einzugsrollen ausgestattete Einzugseinrichtung, die aufeinanderfolgende Abschnitte des Drahts 3 mit einem numerisch gesteuerten Vorschubgeschwindigkeitsprofil in horizontaler Richtung in den Bereich einer Umformeinrichtung 5A, 5B einzieht. Der Draht 3 kann dazu von einem auf einer Haspel 100 des Systems 1 vorgehaltenen Drahtvorrat kommend eingezogen und durch eine nicht gezeigte Richteinheit geführt werden. Der Draht 3 wird vorliegend mithilfe von numerisch gesteuerten Werkzeugen der Umformeinrichtung 5A, 5B in einer Federwindeoperation zu einer Schraubenfeder 2 umgeformt. Zu den Umformwerkzeugen gehören beispielsweise zwei um 90° winkelversetzt angeordnete, radial zur gewünschten Federachse ausgerichtete numerisch gesteuerte Windestifte und wenigstens ein Steigungswerkzeug, um numerisch gesteuert jederzeit die lokale Steigung der sich entwickelten Feder 2 vorzugeben. Die Schnitteinrichtung 5C kann nach Abschluss einer Umformoperation eine fertige Schraubenfeder 2 mit einer linearen Arbeitsbewegung vom zugeführten Draht 3 abtrennen. Die zu den beweglichen Komponenten gehörenden Maschinenachsen der CNC-Federwindemaschine 4 werden vorliegend durch eine nicht gezeigte computernumerische Steuereinrichtung gesteuert.

Die abgetrennten Schraubenfedern 2 werden vorliegend nach dem Abtrennen vom Draht 3 mithilfe des Fördersystems 6 sukzessive im Takt der Federwindemaschine 4 automatisch zu der Nachfolgeeinrichtung 7 gefördert. Abgetrennte Schraubenfedern 2 können insofern mittels des Fördersystems 6 von der Federwindemaschine 4 übernommen und an die Nachfolgeeinrichtung 7 übergeben werden. Die Nachfolgeeinrichtung 7 kann mehrere Meter von der Federwindemaschine 4 entfernt stehen, aber ggf. auch näher.

Die Nachfolgeeinrichtung 7 umfasst beispielsweise eine Wärmebehandlungseinheit 101 für eine kontrollierte Wärmebehandlung der frisch gewundenen Schraubenfedern 2. Einrichtungen zur Qualitätskontrolle der wärmebehandelten Federn und zur Sortierung und Weiterleitung zu wenigstens einer weiteren Nachfolgeanlage 102 sind integriert, die vorliegend auf die Wärmebehandlungseinrichtung 101 folgt.

Die Rohrleitung 8 des Fördersystems 6 weist eine Eintrittsöffnung 9 auf, durch welche hindurch zu transportierende Schraubenfedern 2 in die Rohrleitung 8 hinein eintreten. Das Fördersystem 6 hat eine Aufnahmeeinrichtung 11, die Schraubenfedern 2 von der Federmaschine 4 übernimmt, so dass eine jeweilige übernommene Schraubenfeder 2 von der Federwindemaschine 4 in einer Förderrichtung 12 des Fördersystems 6 durch die Rohrleitung 8 hindurch abtransportiert werden kann.

Die Aufnahmeeinrichtung 11 hat einen Innenraum 13, der einen Initialabschnitt 10 der Rohrleitung 8 ausbildet. Der Initialabschnitt 10 der Rohrleitung 8 kann insbesondere bezüglich der Förderrichtung 12 einen Anfang der Rohrleitung 8 ausbilden. Durch die Eintrittsöffnung 9 hindurch wird ein bereits umgeformter Federabschnitt 14 einer jeweiligen noch in Umformung befindlichen Schraubenfeder 2, also bei laufendem Umformprozess, in den Innenraum 13 hinein eingeführt.

Der Innenraum 13 der Aufnahmeeinrichtung 11 weitet sich von der Eintrittsöffnung 9 weg gerichtet auf. Vorliegend weitet sich der Innenraum 13 in Förderrichtung 12 von der Eintrittsöffnung 9 weg gerichtet auf. Der Innenraum 13 stellt einen Bewegungsfreiraum für den innerhalb des Innenraums 13 befindlichen bereits umgeformten, beispielsweise noch nicht abgetrennten, Federabschnitt 14 bereit.

Die Aufnahmeeinrichtung 11 hat vorliegend eine Übertrittsöffnung 15. Durch die Übertrittsöffnung 15 hindurch tritt eine jeweilige Schraubenfeder 2 aus dem Initialabschnitt 10 der Rohrleitung 8 heraus in einen auf den Initialabschnitt 10 der Rohrleitung 8 folgenden Rohrleitungsabschnitt 16 der Rohrleitung 8 hinüber. Die Übertrittsöffnung 15 liegt der Eintrittsöffnung 9 vorliegend in der Förderrichtung 12 gegenüber. Die Eintrittsöffnung 9 und die Übertrittsöffnung 15 können entlang der Förderrichtung 12 in einer gemeinsamen Flucht angeordnet sein. Beispielsweise hat die Übertrittsöffnung 15 einen Öffnungsquerschnitt, der kleiner ist als ein Öffnungsquerschnitt der Eintrittsöffnung 9.

Der Innenraum 13 weitet sich vorliegend von der Eintrittsöffnung 9 weg gerichtet nur bis zu einer Weitstelle 18 des Innenraums 13 auf. An der Weitstelle 18 hat der Innenraum 13 quer zur Förderrichtung 12 vorliegend seine größte Erstreckung. In Förderrichtung 12 verjüngt sich der Innenraum 13 von der Weitstelle 18 ausgehend wieder bis zu der Übertrittsöffnung 15.

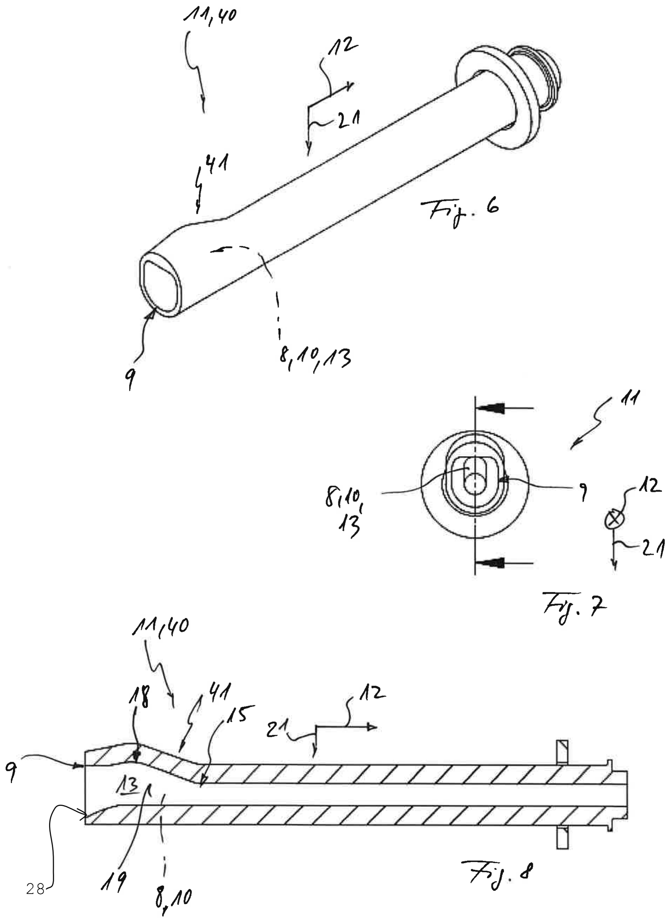

Die Eintrittsöffnung 9 hat beispielsweise einen Öffnungsrand 28, der von dem Innenraum 13 abgewandt ist. Der Öffnungsrand 28 kann zumindest oder nur teilweise gefast oder gerundet ausgebildet ein. Bei den Beispielen nach den Fig. 6 bis 10 ist nur ein bezüglich der Vertikalrichtung 21 unterer Bereich des Öffnungsrands 28 mit einer Einführfase versehen.

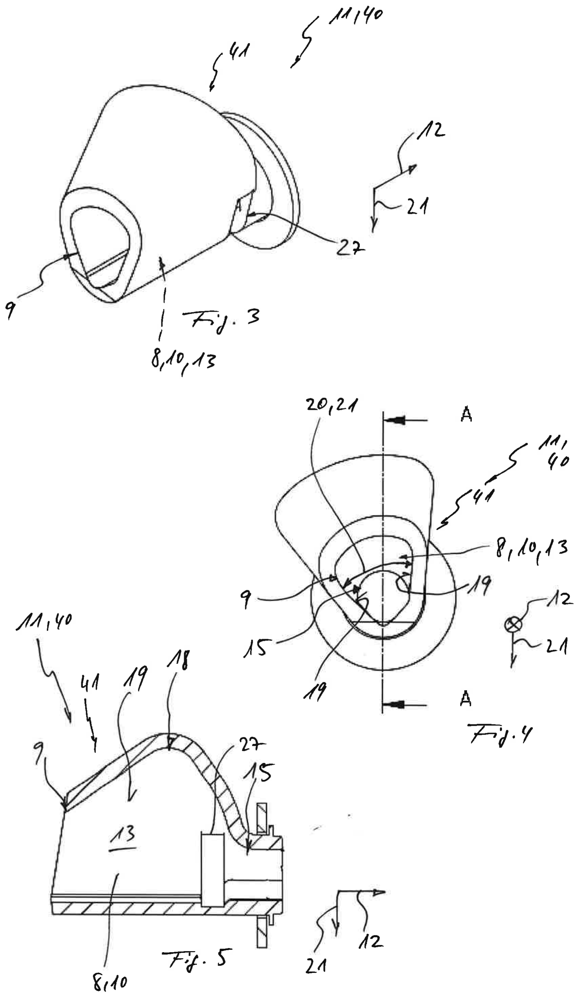

Gemäß den Beispielen nach den Fig. 6 bis 10 ist ein Innenflächenabschnitt der Aufnahmeeinrichtung 11, welcher den sich verjüngenden Abschnitt des Innenraums 13 begrenzt, mit einem Verjüngungswinkel relativ zu der Förderrichtung 12 ausgeführt, der kleiner ist als ein korrespondierender Verjüngungswinkel bei dem Beispiel nach den Fig. 3 bis 5. Ein solcher kleinerer Verjüngungswinkel kann ein Axialende des Federabschnitts 14 besonders schonend in Richtung der Übertrittsöffnung 15 lenken. Dies kann von besonderem Vorteil sein, wenn Schraubenfedern 2 mit relativ großer axialer Federlänge hergestellt werden. Wenn demgegenüber Schraubenfedern 2 mit vergleichsweise kleiner axialer Federlänge hergestellt werden sollen, kann der Verjüngungswinkel größer ausfallen - insbesondere wenn die betreffende relativ kurze Schraubenfeder 2 mit einer, beispielswiese angelegten, letzten Windung von sehr kleiner Steigung erzeugt wird, so dass infolge einer solchen sehr kleine Steigung der letzten Windung ein eigenständiges Ausrichten der Schraubenfeder 2 für den Übertritt durch die Übertrittsöffnung 15 ohne vormaliges Entlanggleiten an dem Verjüngungsinnenflächenabschnitt erfolgen kann.

Beispielsweise hat die Aufnahmeeinrichtung 11 zwei Innenflankenflächen 19, die einander, insbesondere quer zur Förderrichtung 12, gegenüberliegend angeordnet sind. Die beiden Innenflankenflächen 19 der Aufnahmeeinrichtung 11 definieren dabei nur teilweise den Innenraum 13. Die Innenflankenflächen 19 verlaufen vorliegend parallel zu der Förderrichtung 12.

Beispielsweise verläuft zumindest eine der Innenflankenflächen 19 vertikal, also entlang einer Vertikalrichtung 21 des Systems 1. Bei den Ausführungsformen der Fig. 6 bis 10 verlaufen beide Innenflankenflächen 19 parallel zueinander, also beispielsweise beide vertikal oder beide nicht-vertikal. Demgegenüber verläuft bei dem Ausführungsbeispiel der Fig. 3 bis 5 ausschließlich eine der Innenflankenflächen 19 im Wesentlichen vertikal.

Beispielsweise verlässt der bereits umgeformte Federabschnitt 14 einer jeweiligen noch in Umformung befindlichen Schraubenfeder 2 die Federwindemaschine 4 unter einem Schrägwinkel 20 relativ zu der Vertikalrichtung 21. Der Schrägwinkel 20 hängt insbesondere von einer Steigung einer momentan in Umformung befindlichen Windung der Schraubenfeder 2 ab. Wenn eine Schraubenfeder 2 mit sich ändernder Federwindungssteigung hergestellt wird, kann sich insofern der Schrägwinkel 20 im Zuge der Umformung ändern. Bei der Ausführungsform nach den Fig. 3 bis 5 ist dabei ein Winkel 21 zwischen einer nicht-vertikal verlaufenden der Innenflankenflächen 19 und der Vertikalrichtung 21 auf den Schrägwinkel 20 abgestimmt. Der Winkel 21 kann dem Schrägwinkel 20 entsprechen. Insbesondere entspricht der Winkel 21 einem bei der Umformung einer momentan in Herstellung befindlichen Schraubenfeder 2 maximal auftretenden Schrägwinkel 20. Durch die Abstimmung des Winkels 21 auf den Schrägwinkel 20 kann sich der Federabschnitt 14 im Laufe der Umformung zumindest zeitweise an die unter dem Winkel 21 verlaufende Innenflankenfläche 19 anlegen.

Die Federwindemaschine 4 ist vorliegend mit einem kamerabasierten, optischen Messsystem zur berührungslosen Echtzeiterfassung von Daten über die Geometrie einer aktuell hergestellten Feder 2 ausgestattet. Das Messsystem zum Vermessen einer jeweiligen Schraubenfeder 2 kann eine Anzahl an Messkameras 22, 24, 34 des Systems 1 aufweisen. Die Messkameras 22, 24, 34 können als CCD-Videokameras ausgebildet sein. Mit Mitteln der Bilderfassung können aus den Kamerabildern Daten über die Federgeometrie der hergestellten Schraubenfeder 2 ermittelt werden, die in einem Rechner der Steuereinrichtung mit entsprechenden Daten für eine gewünschte Soll-Geometrie verglichen werden. Dadurch ist es möglich, während des Entstehens einer Schraubenfeder 2 den Federwindeprozess zu überwachen und gegebenenfalls über Feedback von Messwerten den Federwindeprozess durch Änderung der Stellwerte von Werkzeugen zu regeln (In-Prozess-Regelung). Außerdem ist es zeitnah mit der Federherstellung möglich, zu erkennen, ob die hergestellte Schraubenfeder 2 ein Gutteil (Federgeometrie im Toleranzbereich) oder ein auszusortierendes Schlechtteil (Federgeometrie außerhalb des Toleranzbereichs) ist. Das optische Messsystem kann insofern als Bestandteil eines Qualitätserfassungssystems fungieren.

Vorliegend ist die Messkamera 22 zum Erfassen einer jeweiligen Schraubenfeder 2 in einer quer zu der Förderrichtung 12 orientierten Erfassungsrichtung 23 der Messkamera 22 ausgebildet. Die Erfassungsrichtung 23 kann einer Blickrichtung der Messkamera 22 entsprechen. Die Messkamera 22 ist vorliegend in Förderrichtung 12 direkt vor der Eintrittsöffnung 9 angeordnet.

Die Messkamera 22 ist vorliegend so installiert ist, dass ihr Bildfeld einen Abschnitt der sich entwickelnden Schraubenfeder 2 in der Nähe der Werkzeuge der Umformeinrichtung 5A, 5B erfassen kann.

Die weitere Messkamera 24 des Systems 1 ist vorliegend zum Erfassen einer jeweiligen Schraubenfeder 2 entlang einer quer zu der Förderrichtung 12 orientierten weiteren Erfassungsrichtung 25 der Messkamera 24 ausgebildet. Die weitere Erfassungsrichtung 25 kann einer Blickrichtung der weiteren Messkamera 24 entsprechen. Die Erfassungsrichtung 23 und die weitere Erfassungsrichtung 25 können parallel zueinander verlaufen. Die weitere Messkamera 24 kann insbesondere die Bestimmung der Federlänge ermöglichen. Alternativ oder zusätzlich kann zur Bestimmung der Federlänge die andere Messkamera 34 vorhanden sein.

Die weitere Messkamera 24 kann in Förderrichtung 12 direkt hinter der Übertrittsöffnung 15 der Aufnahmeeinrichtung 11 angeordnet sein. Alternativ kann die weitere Messkamera 24 in Förderrichtung 12 direkt vor der Übertrittsöffnung 15 angeordnet sein, wie beispielsweise im Falle der Fig. 3 bis 5.

Die Aufnahmeeinrichtung 11 kann ein Kamerafenster 27 aufweisen, vgl. beispielsweise Fig. 3 bis 5. Durch das Kamerafenster 27 hindurch kann die jeweilige Schraubenfeder 2 mittels der weiteren Messkamera 24 erfasst werden. Das Kamerafenster 27 öffnet dabei den Innenraum 13 quer zu der Förderrichtung 12. Beispielsweise kann das Kamerafenster 27 den Innenraum 13 lichtdurchlässig und/oder fluiddurchlässig öffnen.

Das Fördersystem 6 hat vorliegend eine Klemmeinrichtung 29. Die Klemmeinrichtung 29 dient zum Beruhigen einer jeweiligen durch die Rohrleitung 8 hindurch zu transportierenden Schraubenfeder 2. Die Klemmeinrichtung 29 hat eine Druckkammer 31, die mit einem Füllfluid 30 befüllbar ist. Die Klemmeinrichtung 29 hat einen Innendurchmesser 32, der in Abhängigkeit von einem in der Druckkammer 31 herrschenden Füllfluiddruck variabel ist. Die Druckkammer 31 kann insofern mit dem Füllfluid 30 druckbefüllbar sein, um den Innendurchmesser 32 der Klemmeinrichtung 29 kammerinnendruckabhängig einzustellen.

Die Klemmeinrichtung 29 hat eine Umfangswand 33, die an ihrer Innenseite den einstellbaren Innendurchmesser 32 definiert. Dabei dient die Umfangswand 33 dazu, die betreffende Schraubenfeder 2 an der Innenseite der Umfangswand 33 zu berühren. Der Innendurchmesser 32 kann so eingestellt werden, dass die Umfangswand 33 mit ihrer Innenseite einen Außenumfang der betreffenden Schraubenfeder 2 berührt.

Die Druckkammer 31 ist beispielsweise ringförmig umlaufend ausgebildet. Alternativ oder zusätzlich begrenzt die Umfangswand 33 die Druckkammer 31 teilweise.

Die bereits erwähnte andere Messkamera 34 des Systems 1 dient vorliegend zum Erfassen einer jeweiligen Schraubenfeder 2 entlang einer quer zu der Förderrichtung 12 orientierten anderen Erfassungsrichtung 35. Dabei ist die andere Messkamera 34 vorliegend in Förderrichtung 12 direkt hinter der Druckkammer 31 angeordnet. Mittels der Messkamera 34 kann insofern ein durch Einklemmen mittels der Klemmeinrichtung 29 schwingungsberuhigter Abschnitt 14 der Schraubenfeder 2 vermessen werden, beispielsweise um eine axiale Länge der Schraubenfeder 2 zu bestimmen.

Das Fördersystem 6 weist beispielsweise eine Düseneinrichtung 36 auf. Die Düseneinrichtung 36 mündet vorliegend in Förderrichtung 12 hinter dem Initialabschnitt 10 in die Rohrleitung 8 ein. Dabei dient die Düseneinrichtung 36 zum Einspeisen eines Treibfluides 37, welches die Schraubenfedern 2 durch die Rohrleitung 8 hindurch antreibt. Beispielsweise handelt es sich bei dem Treibfluid 37 um Luft 38, insbesondere um Druckluft.

Bei dem Füllfluid 30 zum Befüllen der Druckkammer 31 handelt es sich vorliegend ebenfalls um Luft 38, die insbesondere von derselben Versorgungsquelle stammt, wie die Luft 38 für das Treibfluid 37. Insofern kann es sich auch bei dem Füllfluid 30 zum Befüllen der Druckkammer 31 um Druckluft handeln.

Die Klemmeinrichtung 29 hat vorliegend ein Gehäuse 39, welches monolithisch ausgebildet ist. Alternativ oder zusätzlich kann das Gehäuse 39 - wie vorliegend - additiv hergestellt sein, insbesondere das heißt mittels eines 3D-Druck-Verfahrens. Beispielsweise kann das Gehäuse 39 aus einem Kunststoffmaterial bestehen.

Vorliegend ist das Gehäuse 39 ein gemeinsames Gehäuse der Klemmeinrichtung 29 und der Düseneinrichtung 36.

Die Umfangswand 33 der Klemmeinrichtung 29 bildet vorliegend den bereits erwähnten Rohrleitungsabschnitt 16 der Rohrleitung 8 aus. Der durch die Umfangswand 33 ausgebildete Rohrleitungsabschnitt 16 ist dabei dazu angepasst, fluidleitend an den Innenraum 13 der Aufnahmeeinrichtung 11 des Systems 1 angeschlossen zu werden.

Zumindest ein den Innenraum 13 direkt umgebender Abschnitt 41 der Aufnahmeeinrichtung 11 ist beispielsweise monolithisch ausgebildet. Alternativ oder zusätzlich kann zumindest der den Innenraum 13 direkt umgebende Abschnitt 41 additiv hergestellt sein, insbesondere das heißt mittels eines 3D-Druck-Verfahrens. Zumindest der den Innenraum 13 unmittelbar umgebende Abschnitt 41 der Aufnahmeeinrichtung 11 kann aus einem Kunststoffmaterial bestehen.

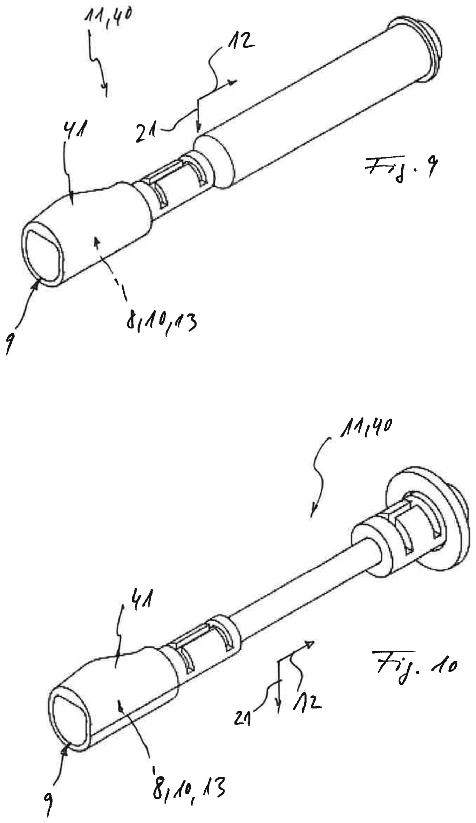

Die Aufnahmeeinrichtung 11 kann als einteilige oder mehrteilige Adaptereinrichtung 40 ausgebildet sein, wobei die Adaptereinrichtung 40 zum Anschließen an den Rohrleitungsabschnitt 16 des Fördersystems 6 ausgebildet ist. In den Beispielen der Fig. 3 bis 8 ist die Aufnahmeeinrichtung 11 als einteilige Adaptereinrichtung 40 ausgebildet. Demgegenüber ist die Aufnahmeeinrichtung 11 bei den Beispielen der Fig. 9 und 10 als mehrteilige Adaptereinrichtung 40 ausgebildet. In dem Beispiel der Fig. 9 ist die Adaptereinrichtung 40 zweiteilig ausgebildet. In dem Beispiel der Fig. 10 ist die Adaptereinrichtung 40 dreiteilig ausgebildet. Die mehrteilige Ausbildung der Adaptereinrichtung 40 kann durch Auswahl von zur Adaptereinrichtung 40 zusammengefügten Teile eine Anpassung der Adaptereinrichtung 40 an einen momentan herzustellenden Typ von Schraubenfedern 2 ermöglichen, insbesondere unter Beibehaltung eines den Innenraum 13 unmittelbar umgebenden und/oder 3D-gedruckten Teils.

Die Rohrleitung 8 kann ein Rohrleitungs-Hauptstück aufweisen, welches sich beispielsweise an den Rohrleitungsabschnitt 16 und/oder das Gehäuse 39 anschließt. Das Rohrleitungs-Hauptstück kann beispielsweise aus einem Kunststoffschlauch aus Polytetrafluorethylen (PTFE) mit einer sehr glatten Rohrinnenseite bestehen, die dafür sorgt, dass auf dem weit überwiegenden Teil der Transportstrecke die Reibungskräfte zwischen Rohrinnenwand und Schraubenfeder 2 gering bleiben. Der Innendurchmesser des Rohrleitungs-Hauptstücks ist geringfügig größer als der maximale Außendurchmesser der Schraubenfeder 2, wobei radial ausreichend Spiel für einen möglichst reibungsarmen Transport bleibt und auch eventuelle Krümmungsabschnitte des Rohrleitung-Hauptstücks ohne Beeinträchtigung der Transportfähigkeit durchlaufen werden können.

Bei der Aufnahmeeinrichtung nach den Fig. 3 bis Fig. 5, die insbesondere für die Herstellung kurzer Schraubenfedern 2 eingerichtet ist, kann die Darstellung der Fig. 4 auch der Einbaulage entsprechen. Demgegenüber kann bei den Aufnahmeeinrichtungen nach den Fig. 6 bis Fig. 10, die insbesondere für die Herstellung langer Schraubenfedern 2 eingerichtet sind, die Einbaulage entweder der Darstellung von Fig. 7 entsprechen oder relativ zu der Darstellung von in Fig. 7 um die Längsachse der betreffenden Ausnahmeeinrichtung 11, insbesondere zur Abstimmung auf den Schrägwinkel 20, gedreht sein.

Beispielsweise können die beiden Innenflankenflächen 19 der Ausführungsformen nach den Fig. 6 bis 10 in Einbaulage schrägwinkelig zu der Vertikalrichtung 21 und zueinander parallel verlaufen.

## Patentansprüche

1. System (1) zur Herstellung von Schraubenfedern (2) aus Draht (3), aufweisend
- eine Federwindemaschine (4), die eine Umformeinrichtung (5A, 5B) zum Umformen ihr zugeführten Drahts (3) in eine Schraubenfeder (2) aufweist, sowie eine Schnitteinrichtung (5C) zum Abtrennen einer jeweiligen umgeformten Schraubenfeder (2) von dem zugeführten Draht (3), und
- ein Fördersystem (6) zum Transportieren abgetrennter Schraubenfedern (2) von der Federwindemaschine (4) zu einer Nachfolgeeinrichtung (7) des Systems (1);
- wobei das Fördersystem (6) eine Rohrleitung (8) aufweist, welche eine Eintrittsöffnung (9) zum Hineintreten durch die Rohrleitung (8) hindurch zu transportierender Schraubenfedern (2) aufweist,
- wobei das Fördersystem (6) eine die Eintrittsöffnung (9) aufweisende und einen Initialabschnitt (10) der Rohrleitung (8) definierende Aufnahmeeinrichtung (11) zum Übernehmen von der Federwindemaschine (4) in einer Förderrichtung (12) des Fördersystems (6) weg zu transportierender Schraubenfedern (2) aufweist,
- wobei die Aufnahmeeinrichtung (11) einen Innenraum (13) aufweist, der den Initialabschnitt (10) der Rohrleitung (8) ausbildet und in welchen hinein durch die Eintrittsöffnung (9) hindurch ein bereits umgeformter Federabschnitt (14) einer jeweiligen noch in Umformung befindlichen Schraubenfeder (2) einführbar ist, **dadurch gekennzeichnet, dass**
- sich der Innenraum (13) der Aufnahmeeinrichtung (11) von der Eintrittsöffnung (9) weg gerichtet aufweitet, um einen Bewegungsfreiraum für den innerhalb des Innenraums (13) befindlichen bereits umgeformten Federabschnitt (14) bereitzustellen.

2. System nach Anspruch 1, **dadurch gekennzeichnet, dass**
- die Aufnahmeeinrichtung (11) eine der Eintrittsöffnung (9) in der Förderrichtung (12), insbesondere fluchtend, gegenüberliegende Übertrittsöffnung (15) zum Übertritt einer jeweiligen Schraubenfeder (2) aus dem Initialabschnitt (10) der Rohrleitung (8) heraus in einen auf den Initialabschnitt (10) der Rohrleitung (8) folgenden Rohrleitungsabschnitt (16) der Rohrleitung (8) hinein aufweist,
- insbesondere wobei die Übertrittsöffnung (15) kleiner als die Eintrittsöffnung (9) ist.

3. System nach Anspruch 2, **dadurch gekennzeichnet, dass**
- sich der Innenraum (13) von der Eintrittsöffnung (9) weg gerichtet nur bis zu einer Weitstelle (18) des Innenraums (13) aufweitet, um sich ab der Weitstelle (18) wieder bis zu der Übertrittsöffnung (15) zu verjüngen.

4. System (1) nach einem der vorhergehenden Ansprüche **dadurch gekennzeichnet, dass**
- die Aufnahmeeinrichtung (11) zwei einander gegenüberliegende Innenflankenflächen (19) aufweist, die den Innenraum (13) teilweise definieren,
- wobei die beiden Innenflankenflächen (19) parallel zu der Förderrichtung (12) verlaufen.

5. System (1) nach Anspruch 4, **dadurch gekennzeichnet, dass**
- wobei zumindest eine der Innenflankenflächen (19) vertikal verläuft.

6. System nach Anspruch 4 oder 5,
- wobei zumindest eine der Innenflankenflächen (19) nicht-vertikal, insbesondere schrägwinkelig zu einer Vertikalrichtung (21) des Systems (1), verläuft; und/oder
- wobei die beiden Innenflankenflächen (19) zueinander parallel verlaufen.

7. System (1) nach einem der Ansprüche 4 bis 6, **dadurch gekennzeichnet, dass**
- der bereits umgeformte Federabschnitt (14) einer jeweiligen noch in Umformung befindlichen Schraubenfeder (2) die Federwindemaschine (4) unter einem, insbesondere federwindungssteigungsabhängigen, Schrägwinkel (20) relativ zu einer Vertikalrichtung (21) des Systems (1) verlässt und
- ein Winkel (21) zwischen zumindest einer, insbesondere nicht-vertikal verlaufenden, der Innenflankenflächen (19) und der Vertikalrichtung (21) auf den Schrägwinkel (20) derart abgestimmt ist, dass sich der Federabschnitt (14) im Laufe der Umformung zumindest zeitweise an die betreffende Innenflankenfläche (19) anlegt.

8. System (1) nach einem der vorhergehenden Ansprüche, **dadurch gekennzeichnet, dass**
- das System (1) eine Messkamera (22) zum Erfassen einer jeweiligen Schraubenfeder (2) in einer quer zu der Förderrichtung (12) orientierten Erfassungsrichtung (23) der Messkamera (22) aufweist,
- wobei die Messkamera (22) in Förderrichtung (12), insbesondere direkt, vor der Eintrittsöffnung (9) angeordnet ist.

9. System (1) nach einem der vorhergehenden Ansprüche, **dadurch gekennzeichnet, dass**
- das System (1) eine, insbesondere weitere, Messkamera (24) zum Erfassen einer jeweiligen Schraubenfeder (2) entlang einer quer zu der Förderrichtung (12) orientierten, insbesondere weiteren, Erfassungsrichtung (25) der, insbesondere weiteren, Messkamera (24) aufweist,
- wobei die, insbesondere weitere, Messkamera (24) in Förderrichtung (12), insbesondere direkt, hinter einer Übertrittsöffnung (15) der Aufnahmeeinrichtung (11) oder, insbesondere direkt, vor der Übertrittsöffnung (15) angeordnet ist.

10. System (1) nach Anspruch 8, **dadurch gekennzeichnet, dass**
- die Aufnahmeeinrichtung (11) ein Kamerafenster (27) aufweist, durch welches hindurch die jeweilige Schraubenfeder (2) mittels der, insbesondere weiteren, Messkamera (24) erfassbar ist,
- wobei das Kamerafenster (27) den Innenraum (13) quer zu der Förderrichtung (12), insbesondere lichtdurchlässig und/oder fluiddurchlässig, öffnet.

11. System (1) nach einem der vorhergehenden Ansprüche,
- wobei ein von dem Innenraum (13) abgewandter Öffnungsrand (28) der Eintrittsöffnung (9), insbesondere zumindest oder nur teilweise, gefast oder gerundet ausgebildet ist.

12. System (1) nach einem der vorhergehenden Ansprüche oder nach dem Oberbegriff von Anspruch 1, **dadurch gekennzeichnet, dass**
- das Fördersystem (6) eine Klemmeinrichtung (29) zum Beruhigen einer jeweiligen durch die Rohrleitung (8) hindurch zu transportierenden Schraubenfeder (2) aufweist,
- wobei die Klemmeinrichtung (29) eine mit einem Füllfluid (30) druckbefüllbare Druckkammer (31) zum kammerinnendruckabhängigen Einstellen eines Innendurchmessers (32) der Klemmeinrichtung (29) aufweist,
- wobei eine zum Beruhigungsberühren der betreffenden Schraubenfeder (2) ausgebildete Umfangswand (33) der Klemmeinrichtung (29) den einstellbaren Innendurchmesser (32) definiert.

13. System (1) nach Anspruch 11, **dadurch gekennzeichnet, dass**
- die Druckammer (31) ringförmig umlaufend ausgebildet ist; und/oder
- dass die Umfangswand (33) die Druckkammer (31) teilweise begrenzt.

14. System (1) nach Anspruch 11 oder 12, **dadurch gekennzeichnet, dass**
- das System (1) eine, insbesondere andere, Messkamera (34) zum Erfassen einer jeweiligen Schraubenfeder (2) entlang einer quer zu der Förderrichtung (12) orientierten, insbesondere anderen, Erfassungsrichtung (35) aufweist,
- wobei die, insbesondere andere, Messkamera (34) in Förderrichtung (12), insbesondere direkt, hinter der Druckkammer (31) angeordnet ist.

15. System (1) nach einem der vorhergehenden Ansprüche, **dadurch gekennzeichnet, dass**
- das Fördersystem (6) eine in Förderrichtung (12) hinter dem Initialabschnitt (10) in die Rohrleitung (8) einmündende Düseneinrichtung (36) zum Einspeisen eines Treibfluides (37) zum Antreiben von Schraubenfedern (2) durch die Rohrleitung (8) hindurch aufweist,
- insbesondere wobei es sich bei dem Treibfluid (37) und/oder bei dem Füllfluid (30) zum Befüllen der Druckkammer (31) um, insbesondere von derselben Versorgungsquelle stammende, Luft (38), insbesondere Druckluft, handelt.

16. System (1) nach einem der Ansprüche 11 bis 14, **dadurch gekennzeichnet, dass**
- die Klemmeinrichtung (29) und die Düseneinrichtung (36) ein gemeinsames Gehäuse (39) aufweisen.

17. Aufnahmeeinrichtung (11) für ein System (1) nach einem der vorhergehenden Ansprüche, **dadurch gekennzeichnet, dass**
- die Aufnahmeeinrichtung (11) als einteilige oder mehrteilige Adaptereinrichtung (40) zum Anschließen an einen Rohrleitungsabschnitt (16) des Fördersystems (6) ausgebildet ist; und/oder dass
- zumindest ein den Innenraum (13) definierender Abschnitt (41) der Aufnahmeeinrichtung (11) monolithisch ausgebildet und/oder additiv hergestellt ist.

18. Klemmeinrichtung (29) für ein System nach einem der Ansprüche 11 bis 15, **dadurch gekennzeichnet, dass**
- die Umfangswand (33) einen Rohrleitungsabschnitt (16) ausbildet, der zum fluidleitenden Anschließen des Innenraums (13) einer Aufnahmeeinrichtung (11) des Systems (1) angepasst ist; und/oder dass
- ein Gehäuse (39) der Klemmeinrichtung (29) monolithisch ausgebildet und/oder additiv hergestellt ist.
